# EUROPEAN PATENT APPLICATION

(11) **EP 4 793 784 A1**
(43) Date of publication of application: **19.08.2026**
(21) Application number: 25158289.6
(22) Date of filing: 17.02.2025
(51) Int. Cl.: G06F 13/42

(54) **SERIAL COMMUNICATION DEVICE FOR I2C OR I3C COMMUNICATION AND METHOD**

(71) Applicant: NXP B.V., 5656 AG Eindhoven (NL)
(72) Inventor: Kramer, Joachim Torsten, 5656AG Eindhoven (NL); Cyriac, Deepu, 5656AG Eindhoven (NL)
(74) Representative: Schwarzweller, Thomas

(57) **Abstract**

A serial communication device for I2C or I3C communication and method is described. The serial communication device includes a serial data (SDA) terminal coupled to a series arrangement of a SDA filter and a SDA programable delay circuit. The serial communication device includes a serial clock (SCL) terminal coupled to a series arrangement of a SCL filter and a SCL programable delay circuit. In response to detecting a start condition, a first count value is generated by a first counter during a first time duration corresponding to a SDA filter propagation delay time, a second count value is generated by a second counter during a second time duration corresponding to a SCL filter propagation delay time. A delay of at least one of the SDA programable delay circuit and the SCL programable delay circuit determined from the first count value and the second count value.

## Description

### FIELD

This disclosure relates to a serial communication device for Inter Integrated Circuit (I2C) or Improved Inter-Integrated Circuit (I3C) communication and a method of serial communication for I2C or I3C.

### BACKGROUND

The Inter Integrated Circuit (I2C) communication bus uses a synchronous serial communication bus which may have multiple controllers and multiple targets connected. The related Improved Inter-Integrated Circuit bus (I3C) uses the same two-wire data and clock connection and has some backward compatibility with I2C. The I2C and I3C communication protocols offer different communication speed modes. For the standard communication modes a spike filter is required for the serial clock (SCL) and serial data (SDA) signals that filter out all spikes with a duration shorter than 50 nano seconds. Typically such filters are implemented in pad instances as combinatorial logic.

Large and often unavoidable variances of propagation delays in the spike filters can lead to a timing violation of the I2C or I3C communication protocol specification. Such timing violations may result in a yield loss if the violation is detected during wafer testing or may result in reduced reliability of operation.

### SUMMARY

Aspects of the disclosure are defined in the accompanying claims. In a first aspect, there is provided a method of operating a serial communication device for I2C or I3C communication, the serial communication device comprising a serial data, SDA, terminal coupled to a series arrangement of a SDA filter and a SDA programable delay circuit and a serial clock, SCL, terminal coupled to a series arrangement of a SCL filter and a SCL programable delay circuit, the method comprising, in response to detecting a start condition: generating a first count value by a first counter during a first time duration corresponding to a SDA filter propagation delay time; generating a second count value by a second counter during a second time duration corresponding to a SCL filter propagation delay time; programming a delay of at least one of the SDA programable delay circuit and the SCL programable delay circuit determined from the first count value and the second count value.

In some embodiments, wherein programming a delay of at least one of the SDA programable delay circuit and the SCL programable delay circuit further comprises: determining a programming value corresponding to a difference between the first count value and the second count value; programming the delay of one of the SDA programable delay circuit and the SCL programable delay circuit with the programming value; and programming the delay of the other of the SDA programable delay circuit and the SCL programable delay circuit with a minimum value.

In some embodiments, the minimum delay value is zero. In some embodiments, the method further comprises initially setting the SDA programable delay circuit and the SCL programable delay circuit to the same value. In some embodiments, the first time duration corresponds to a time difference between a SDA signal transition of a SDA signal received on the SDA terminal and provided to the SDA filter and a filtered SDA signal transition of a filtered SDA signal. In some embodiments, the SDA signal transition and the filtered SDA signal transition is a transition from a logic high level to a logic low level. In some embodiments, the second time duration corresponds to a time difference between a SCL signal transition of a SCL signal received on the SCL terminal and provided to the SCL filter and a filtered SCL signal transition of a filtered SCL signal. In some embodiments, wherein the SCL signal transition and the filtered SCL signal transition is a transition from a logic high level to a logic low level.

In a second aspect, there is provided a serial communication device for I2C or I3C communication, the serial communication device comprising: a serial data, SDA, terminal coupled to a series arrangement of a SDA filter and a SDA programable delay circuit; a serial clock, SCL, terminal coupled to a series arrangement of a SCL filter and a SCL programable delay circuit; a SCL delay counter and a SDA delay counter ; an oscillator coupled to the SCL delay counter and the SDA counter; logic circuitry configured and arranged to: detect a start condition; enable the oscillator to provide a clock to a first counter to count to a first count value during a first time duration corresponding to a SDA filter propagation delay time; enable the oscillator to provide a clock to a second counter to count to a second count value during a second time duration corresponding to a SCL filter propagation delay time; and program a delay of at least one of the SDA programable delay circuit and the SCL programable delay circuit determined from the first count value and the second count value.

In some embodiments, the serial communication device further comprises an oscillator configured to be coupled to the first counter and the second counter and wherein the logic circuitry is further configured and arranged to enable the oscillator to provide a clock signal to the first counter for the first time duration and enable the oscillator to provide a clock signal to the second counter for the second time duration.

In some embodiments, the SCL programable delay circuit; and the SDA programable delay circuit comprise plurality of delay stages wherein the delay through each delay stage corresponds to a time period of the clock signal.

In some embodiments, the logic circuitry comprises: a first logic gate having a first logic gate first input coupled to the SDA terminal, a first logic gate second input coupled to a SDA programmable delay circuit output, and a first logic gate output (SDA COUNTER ENABLE), wherein the first logic gate is configured to output a SDA count enable signal in response to detecting the start condition; a second logic gate having a second logic gate first input coupled to the SCL terminal, a second logic gate second input coupled to a SCL programmable delay circuit output, and a second logic gate output configured to output a SCL count enable signal in response to a transition on the SCL terminal (SCL COUNTER ENABLE); a third logic gate having a third logic gate first input coupled to the first logic gate output, a third logic gate second input coupled to the second logic gate output and a third logic gate output coupled to an oscillator input of an oscillator and configured to enable the oscillator in response to either the SDA count enable signal or the SCL count enable signal; a fourth logic gate having a fourth logic gate first input coupled to a first logic gate output; an oscillator output coupled to a fourth logic gate second input, and a fourth logic gate output coupled to a SDA counter clock input of an SDA delay counter; a fifth logic gate having a fifth logic gate first input coupled to a first logic gate output; an oscillator output coupled to a fifth logic gate second input, and a fifth logic gate output coupled to a SCL counter clock input of an SCL delay counter; a comparator having a first comparator input coupled to the SDA delay counter output and a second comparator input coupled to the SCL delay counter output; a first comparator output coupled to a SDA programmable delay circuit control input and configured to provide a SDA programmable delay value to the SDA programmable delay circuit and a second comparator output coupled to a SCL programmable delay circuit control input configured to provide a SCL programmable delay value to the SCL programmable delay circuit. In some embodiments, the first logic gate, second logic gate, fourth logic gate and fifth logic gate is an AND gate, and the third logic gate is an OR gate.

In some embodiments, the SDA programmable delay circuit and SCL programmable delay circuit comprises a delay circuit, the delay circuit comprising: a delay circuit input; a delay circuit output; a programmable delay circuit input; a multiplexer comprising a plurality of multiplexer inputs, a multiplexer output and a multiplexer select input coupled to the programmable delay circuit input; a series arrangement of a plurality of delay stages (340), a first delay stage of the plurality of delay stages having an input coupled to the programmable delay circuit input; each delay stage comprising a series arrangement of two delay cells, wherein connections between delay stages are coupled to a respective multiplexer input of the plurality of multiplexer inputs, and a multiplexer output is coupled to the delay circuit output.

In some embodiments, the oscillator comprises: a delay cell; a logic circuit comprising a first input coupled to a delay cell output, a second input coupled to an enable input and an output coupled to a delay cell input; wherein the oscillator is configured to oscillate in response to the enable input being asserted.

In some embodiments, the first logic gate, the second logic gate, the third logic gate and the fourth logic comprise an AND gate, and the fifth logic gate comprises an OR gate.

In some embodiments, the first time duration corresponds to a time difference between a SDA signal transition of a SDA signal received on the SDA terminal and provided to the SDA filter and a filtered SDA signal transition of a filtered SDA signal.

In some embodiments, the SDA signal transition and the filtered SDA signal transition is a transition from a logic high level to a logic low level.

In some embodiments, the second time duration corresponds to a time difference between a SCL signal transition of a SCL signal received on the SCL terminal and provided to the SCL filter and a filtered SCL signal transition of a filtered SCL signal.

In some embodiments, the SCL signal transition and the filtered SCL signal transition is a transition from a logic high level to a logic low level.

### BRIEF DESCRIPTION OF THE DRAWINGS

In the figures and description like reference numerals refer to like features. Embodiments are now described in detail, by way of example only, illustrated by the accompanying drawings in which:
Figure 1 shows a typical I2C or I3C communication pad with a filter.
Figure 2 illustrates a serial communication device for I2C or I3C according to an embodiment.
Figure 3 shows an example oscillator implementation for the serial communication device of figure 2.
Figure 4 illustrates an example programmable delay circuit for the serial communication device of figure 2.
Figure 5 shows a timing waveform illustrating the operation of the serial communication device of figure 2
Figure 6 illustrates a method of operation of a serial communication for I2C or I3C according to an embodiment.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION OF EMBODIMENTS

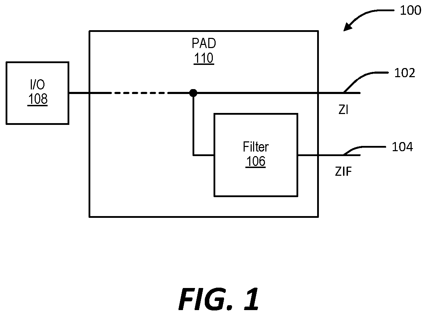

Figure 1 shows a typical I2C interface 100 including a pad 112 having a filter 106. An input/output terminal 108 is connected to the unfiltered signal input 102. The unfiltered signal input 102 is connected to an input of the spike filter 106. In operation when in target mode an input signal ZI is received on the I/O terminal 108. The filtered signal ZIF is output on filter output 104 receiving an input signal. The spike filter has typically a large variance in propagation delay, depending on manufacturing and operational variations due to process voltage temperature (PVT). For the I2C protocol two pads 112 are used each having a respective filter. Depending on the PVT conditions, the propagation delay range is typically in a range of 60 to 120 ns, leading in a variance of propagation delay of two pads of up to 60 ns. The I2C specification requires a variance of significantly below 50 ns to meet the specification, in particular with regard to the setup and hold times.

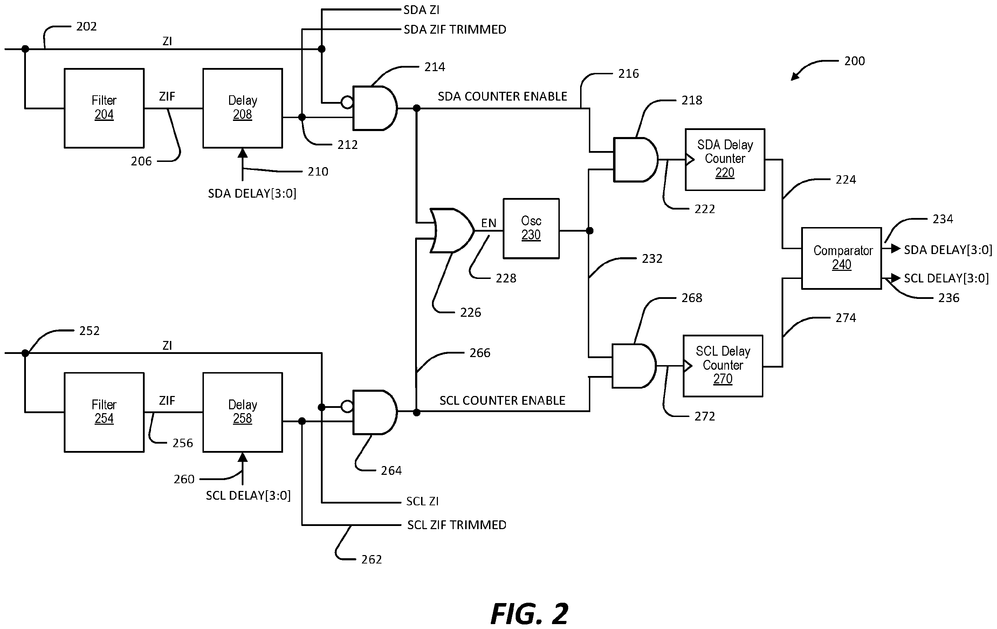

Figure 2 shows an I2C or I3C serial communication interface 200 according to an embodiment. An SDA input 202 is connected to SDA terminal (not shown) and a SDA filter input of and SDA (spike) filter 204. The SDA filter output 206 is connected to a delay input of SDA programmable delay 208. The SDA programmable delay 208 has a SDA delay control input 210 which as illustrated is 4 bits wide. In other embodiments the delay control input 210 may have fewer or more than 4 bits. A programmable delay output 212 is connected to a non-inverting input of a first AND gate 214. The SDA input is connected to an inverting input of the first AND gate 214. A first AND gate output 216 is connected to a first input of a second AND gate 218 and a first input of OR gate 226.

An SCL input 252 is connected to a SCL filter input of and SCL (spike) filter 254. The SCL filter output 256 is connected to a delay input of SCL programmable delay 258. The SCL programmable delay 258 has a SCL delay control input 260 which as illustrated is 4 bits wide. In other embodiments the delay control input 260 may have fewer or more than 4 bits. A programmable delay output 262 is connected to a non-inverting input of a third AND gate 264. The SCL input is connected to an inverting input of the third AND gate 264. A third AND gate output 266 is connected to a first input of a fourth AND gate 268 and a second input of OR gate 226.

The output of OR gate 226 is connected to an enable input 228 of an oscillator 230. The oscillator output 232 is connected to a second input of the second AND gate 218 and a second input of the fourth AND gate 268. The output of the second AND gate 218 is connected to a clock input 222 of SDA delay counter 220. The SDA delay counter output 224 is connected to a first input of the comparator 240. The output of the fourth AND gate 268 is connected to a clock input 272 of SCL delay counter 270. The SCL delay counter output 274 is connected to a second input of the comparator 240.

A first comparator output 234 is connected to SDA delay control input 210. A second comparator output 236 is connected to SCL delay control input 210. The AND gates 214, 218, 264, 268, OR gate 226 and comparator provide logic circuitry to detect the I2C start condition and enable the oscillator for two time durations corresponding to the delay through the respective SDA filter 204 and SCL filter 254. It will be appreciated that other embodiments may implement different logic circuitry to perform the same function.

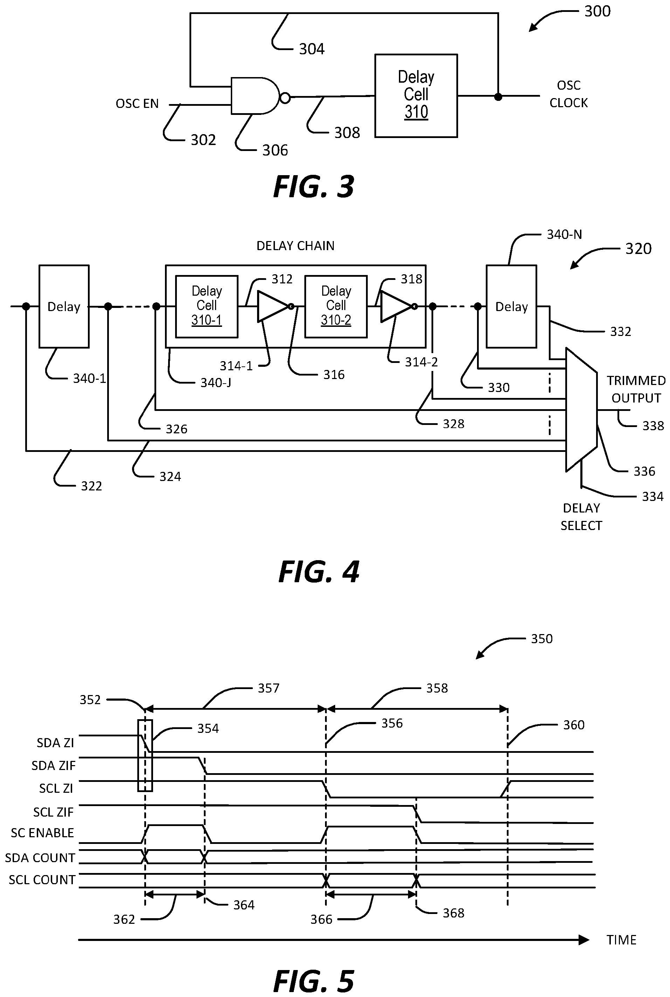

Figure 3 shows an oscillator 300 which may for example be used to implement oscillator 230. An oscillator enable input 302 is connected to a first input of NAND gate 306. The NAND gate output is connected to an input of a delay cell 310. The delay cell output is connected to the oscillator output 304 and a second input of NAND gate 306. The delay cell 310 may be implemented by any circuit that adds a delay to the propagation of signals. For example a delay cell may be implemented in CMOS technology with a number of transistors in addition to passive elements such as resistors or capacitors. Alternatively delay cell 310 may be implemented as a concatenation of standard library cells such as inverters and/or buffers. In general, each standard buffer or series arrangement of two inverters may function as a delay cell.

Figure 4 shows a programmable delay 320 which may for example be used to implement SDA programmable delay 208 or SCL programmable delay 258. The programmable delay 320 includes a series arrangement of N delay stages 310 (310-1, 310-J, 310-N). The connections 322, 324, 326, 328, 330, 332 from points between delay stages 310-1, 310-J, 310-N are connected to a multiplexer 336. Referring now to intermediate delay stage 310-J which shows an example implementation of delay stages 310, delay stage 340-J includes a first delay cell 310-1 having an input connected to connection 326 and an output connected to an input 312 of first inverter 314-1. The first inverter output 316 is connected to an input of a second delay cell 310-2. An output of the second delay cell 310-2 is connected to an input 318 of a second inverter 314-2. An output of the second inverter is connected to the multiplexer and the following delay stage (not shown) via connection 328. The delay cells 310 are identical to the delay cell used in the oscillator 300 which may result in a propagation delay through a delay stage 340-J having the same time period as the time period of the clock signal output by the oscillator 300.

Figure 5 shows a timing waveform 350 illustrating an example operation of the interface 200. The delay values of SDA programmable delay 208 and SCL programmable delay 258 are initially programmed to the same value. In some examples, this value may correspond to a minimum delay which may be effectively considered as a zero delay. An I2C (or I3C) start condition 354 is detected when an SDA ZI signal received on SDA input 202 has a negative transition 352 from a logic HIGH voltage value to a logic LOW voltage value while the SCL ZI signal on SCL input 252 remains at a logic HIGH value. The first NAND gate 214 outputs an SDA counter enable signal for a time duration 362 corresponding to the time between the SDA ZI signal negative transition and the filtered signal SDA ZIF having a corresponding negative transition 364. The time between the successive transitions corresponds to the time delay through the SDA filter 204. The SDA counter enable signal enables the oscillator 230 via OR gate 226 shown be the waveform SC ENABLE. The oscillator 230 generates a clock with a clock period corresponding to a programmable delay stage for example delay stage 340 of SDA programmable delay 208. The SDA delay counter 220 increments the counter each clock cycle ending with a counter value corresponding to the time duration 362. The time durations 357, 358 are the setup times between data and clock transitions which may be greater than 250 ns.

At a later time than the start condition 354, the SCL ZI signal on SCL input 252 has a negative transition 356 from a logic HIGH voltage value to a logic LOW voltage value. The third NAND gate 264 outputs an SCL counter enable signal for a time duration 362 corresponding to the time between the SCL ZI signal and the filtered signal SDA ZIF having a corresponding negative transition 364 i.e. representing the time delay through the SCL filter 254. The SCL counter enable signal enables the oscillator 230 via OR gate 226 shown by the waveform SC ENABLE. The SCL delay counter 270 increments to a counter value corresponding to the time duration 366.

The comparator 240 receives the counter values from the SDA delay counter 220 and the SCL delay counter 270 and outputs a SDA delay control value and SCL delay control value on first and second comparator outputs 234, 236 respectively. In some examples the SDA delay value and SCL delay value may be the respective counter values. In other examples if the SDA counter value is higher than the SCL counter value, the SDA delay value may represent the difference between the SDA counter value and the SCL counter value and the SCL delay value may be zero. In other examples if the SCL counter value is higher than the SDA counter value, the SCL delay value may represent the difference between the SCL counter value and the SDA counter value and the SDA delay value may be zero. The comparator outputs 234, 236 set the trimmed delay chain control values on the SDA programmable delay and the SCL programmable delay respectively for the remaining I2C frame. During the I2C start condition, the timing requirements are not critical for the range (spread) of filter delay values. Consequently the untrimmed operation mode is acceptable for the calibration operation.

Embodiments of the serial communication interface include an oscillator and a programmable delay chain. The propagation delay of one delay chain element may match to the resp. clock period of the oscillator. The oscillator is used to drive a counter that measures differences of propagation delays in two or more data paths. The resulting counter value is used as configuration value for the programmable delay chain to balance or trim the propagation delays of the data paths.

Embodiments of the serial communication may provide a power efficient and accurate delay trimming without the need of an (external) clock source. This allows the use of simpler analog spike filters rather than using digital filters with a dedicated relatively high frequency oscillator which results in increased power consumption.

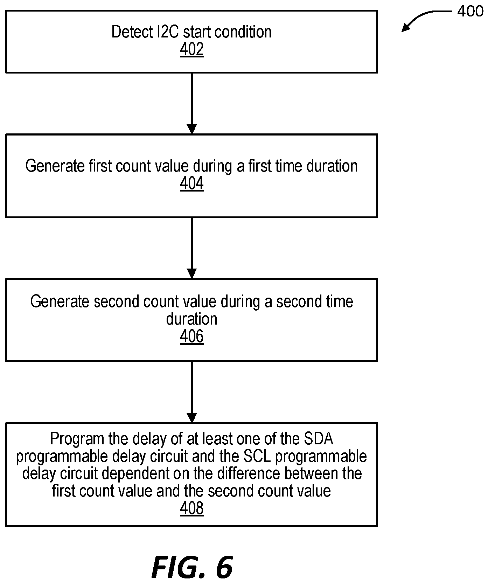

Figure 6 shows a method 400 of calibrating a I2C or I3C target device comprising a SDA terminal and a SCL terminal, each of the SDA terminal and the SCL terminal coupled to a respective series arrangement of a respective filter coupled to a programable delay circuit according to an embodiment. In step 402 an I2C start condition is detected. In step 404 a first count value is generated during a first time duration representing the delay through the SDA filter. In step 406 a second count value is generated during a second time duration representing the delay through the SCL filter. In step 408, the delay of at least one of an SDA programmable delay circuit and an SCL programmable delay circuit is set dependent on the first count value and the second count value.

Embodiments of the serial communication interface may provide improved trimming accuracy or avoid the requirement to implement filters as a digital filter with a dedicated fast running oscillator in any device or circuit that provides an I2C or I3C interface that is connected to the internal I2C hardware. These interfaces contain very often spike filters, that have typically a large spread of propagation delay. The propagation delay is influenced by temperature, voltage and process (PVT) and can vary significantly between filters on the same device.

The embodiments of the serial interface provide an automatic trimming of path delays at every start of communication. This automatic trimming may ensure that the difference of propagation delays for both SCL and SDA paths is below the required threshold to comply with the I2C specification independently of voltage, temperature and process conditions.

A serial communication device for I2C or I3C communication and method is described. The serial communication device includes a serial data (SDA) terminal coupled to a series arrangement of a SDA filter and a SDA programable delay circuit. The serial communication device includes a serial clock (SCL) terminal coupled to a series arrangement of a SCL filter and a SCL programable delay circuit. In response to detecting a start condition, a first count value is generated by a first counter during a first time duration corresponding to a SDA filter propagation delay time, a second count value is generated by a second counter during a second time duration corresponding to a SCL filter propagation delay time. A delay of at least one of the SDA programable delay circuit and the SCL programable delay circuit is determined from the first count value and the second count value.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A method of operating a serial communication device for I2C or I3C communication, the serial communication device comprising a serial data, SDA, terminal coupled to a series arrangement of a SDA filter and a SDA programable delay circuit and a serial clock, SCL, terminal coupled to a series arrangement of a SCL filter and a SCL programable delay circuit, the method comprising, in response to detecting a start condition:
generating a first count value by a first counter during a first time duration corresponding to a SDA filter propagation delay time;
generating a second count value by a second counter during a second time duration corresponding to a SCL filter propagation delay time; and
programming a delay of at least one of the SDA programable delay circuit and the SCL programable delay circuit determined from the first count value and the second count value.

2. The method of claim 1 wherein programming a delay of at least one of the SDA programable delay circuit and the SCL programable delay circuit further comprises:
determining a programming value corresponding to a difference between the first count value and the second count value;
programming the delay of one of the SDA programable delay circuit and the SCL programable delay circuit with the programming value; and
programming the delay of the other of the SDA programable delay circuit and the SCL programable delay circuit with a minimum value.

3. The method of claim 2, wherein the minimum delay value is zero.

4. The method of any preceding claim, further comprising initially setting the SDA programable delay circuit and the SCL programable delay circuit to the same value.

5. The method of any preceding claim, wherein the first time duration corresponds to a time difference between a SDA signal transition of a SDA signal received on the SDA terminal and provided to the SDA filter and a filtered SDA signal transition of a filtered SDA signal.

6. The method of claim 5, wherein the SDA signal transition and the filtered SDA signal transition is a transition from a logic high level to a logic low level.

7. The method of any preceding claim, wherein the second time duration corresponds to a time difference between a SCL signal transition of a SCL signal received on the SCL terminal and provided to the SCL filter and a filtered SCL signal transition of a filtered SCL signal.

8. The method of claim 7, wherein the SCL signal transition and the filtered SCL signal transition is a transition from a logic high level to a logic low level.

9. A serial communication device for I2C or I3C communication, the serial communication device comprising:
a serial data, SDA, terminal coupled to a series arrangement of a SDA filter and a SDA programable delay circuit;
a serial clock, SCL, terminal coupled to a series arrangement of a SCL filter and a SCL programable delay circuit;
a SCL delay counter and a SDA delay counter ;
an oscillator coupled to the SCL delay counter and the SDA counter;
logic circuitry configured and arranged to:
detect a start condition;
enable the oscillator to provide a clock to a first counter to count to a first count value during a first time duration corresponding to a SDA filter propagation delay time;
enable the oscillator to provide a clock to a second counter to count to a second count value during a second time duration corresponding to a SCL filter propagation delay time; and
program a delay of at least one of the SDA programable delay circuit and the SCL programable delay circuit determined from the first count value and the second count value.

10. The serial communication device of claim 9 further comprising an oscillator configured to be coupled to the first counter and the second counter and wherein the logic circuitry is further configured and arranged to enable the oscillator to provide a clock signal to the first counter for the first time duration and enable the oscillator to provide a clock signal to the second counter for the second time duration.

11. The serial communication device of claim 10, wherein the SCL programable delay circuit; and the SDA programable delay circuit comprise a plurality of delay stages, wherein the delay through each delay stage corresponds to a time period of the clock signal.

12. The serial communication device of claim 11, wherein the logic circuitry comprises:
a first logic gate having a first logic gate first input coupled to the SDA terminal, a first logic gate second input coupled to a SDA programmable delay circuit output, and a first logic gate output, wherein the first logic gate is configured to output a SDA count enable signal in response to detecting the start condition;
a second logic gate having a second logic gate first input coupled to the SCL terminal, a second logic gate second input coupled to a SCL programmable delay circuit output, and a second logic gate output configured to output a SCL count enable signal in response to a transition on the SCL terminal;
a third logic gate having a third logic gate first input coupled to the first logic gate output, a third logic gate second input coupled to the second logic gate output and a third logic gate output coupled to an oscillator input of an oscillator and configured to enable the oscillator in response to either the SDA count enable signal or the SCL count enable signal;
a fourth logic gate having a fourth logic gate first input coupled to a first logic gate output; an oscillator output coupled to a fourth logic gate second input, and a fourth logic gate output coupled to a SDA counter clock input of an SDA delay counter ;
a fifth logic gate having a fifth logic gate first input coupled to a first logic gate output; an oscillator output coupled to a fifth logic gate second input, and a fifth logic gate output coupled to a SCL counter clock input of an SCL delay counter ; and
a comparator having a first comparator input coupled to the SDA delay counter output and a second comparator input coupled to the SCL delay counter output; a first comparator output coupled to a SDA programmable delay circuit control input and configured to provide a SDA programmable delay value to the SDA programmable delay circuit and a second comparator output coupled to a SCL programmable delay circuit control input configured to provide a SCL programmable delay value to the SCL programmable delay circuit.

13. The serial communication device of claim 12, wherein the first logic gate, second logic gate, fourth logic gate and fifth logic gate is an AND gate, and the third logic gate is an OR gate.

14. The serial communication device of any of claims 9 to 13, wherein the SDA programmable delay circuit and SCL programmable delay circuit comprises a delay circuit, the delay circuit comprising:
a delay circuit input;
a delay circuit output;
a programmable delay circuit input;
a multiplexer comprising a plurality of multiplexer inputs, a multiplexer output and a multiplexer select input coupled to the programmable delay circuit input; and
a series arrangement of a plurality of delay stages, a first delay stage of the plurality of delay stages having an input coupled to the programmable delay circuit input; each delay stage comprising a series arrangement of two delay cells, wherein connections between delay stages are coupled to a respective multiplexer input of the plurality of multiplexer inputs, and a multiplexer output is coupled to the delay circuit output.

15. The serial communication device of claim 14 wherein the oscillator comprises:
a delay cell;
a logic circuit comprising a first input coupled to a delay cell output, a second input coupled to an enable input and an output coupled to a delay cell input; and
wherein the oscillator is configured to oscillate in response to the enable input being asserted.
